# EUROPEAN PATENT APPLICATION

(11) **EP 1 928 172 A2**
(43) Date of publication of application: **04.06.2008**
(21) Application number: 07022011.6
(22) Date of filing: 13.11.2007
(51) Int. Cl.: H04N 5/64

(54) **Television image receiver**

(30) Priority: 29.11.2006 JP 2006321365; 29.11.2006 JP 2006321372; 29.11.2006 JP 2006321651; 26.04.2007 JP 2007116581
(71) Applicant: Sanyo Electric Co., Ltd., Osaka 570-8677 (JP); Sanyo Visual Technology Inc., Daito-shi Osaka 574-8534 (JP)
(72) Inventor: Nakamichi, Masaya, Kyoto 619-0216 (JP); Sakakibara, Masanori, Nara 630-8001 (JP)
(74) Representative: Glawe, Delfs, Moll

(57) **Abstract**

A television image receiver (1) includes: an internal pressure regulating valve (5) provided above a tightly sealed cabinet (2), for allowing ventilation inside and outside the cabinet (2); and moisture adjustors (7), each having a moisture absorbing function, fixed inside the cabinet (2). The internal pressure regulating valve (5) includes a ventilation filter (6), which allows air and water vapor to pass therethrough but prevents water from permeating therethrough, inside a valve body (50). The internal pressure regulating valve (5) alleviates change in pressure inside the cabinet (2). Water vapor outside the cabinet (2) enters the cabinet (2) through the internal pressure regulating valve (5). When a temperature inside the cabinet (2) is decreased, the moisture adjustor (7) absorbs the water vapor to decrease the relative humidity, thus preventing occurrence of condensation.

## Description

### BACKGROUND OF THE INVENTION

### Field of the Invention

The present invention relates to a television image receiver which is assumed to be used outdoors in an environment exposed to wind and rain.

### Description of the Related Art

A television image receiver having a tightly sealed cabinet has been hitherto proposed on the assumption that the television image receiver is used in a damp environment such as a bathroom (see Japanese Laid-Open Patent Publication No. 2006-158096). A similar cabinet structure is also applied to a television image receiver which is assumed to be used outdoors in an environment exposed to wind and rain.

Since the cabinet is tightly sealed, and further, the television image receiver is used outdoors, pressure inside the cabinet is varied due to an abrupt change in temperature, which may cause damage on the cabinet. As a countermeasure against such a situation, a conceivable method is that an internal pressure regulating valve is disposed in the cabinet so as to allow air to pass inside and outside the cabinet, thereby controlling the change in pressure inside the cabinet caused by the abrupt change in temperature.

However, if the internal pressure regulating valve allows air to flow through the inside and outside of the cabinet, water vapor unfavorably enters the cabinet. As a consequence, when the temperature goes down, condensation occurs inside the cabinet, thereby giving an adverse effect on electric parts inside the cabinet. In addition, it is necessary to prevent heat from being confined inside the cabinet.

An object of the present invention is to provide a television image receiver simultaneously capable of controlling changes in internal pressure of a cabinet and preventing occurrence of condensation inside the cabinet. Furthermore, another object of the invention is to enhance a heat radiating effect of the cabinet.

### SUMMARY OF THE INVENTION

A television image receiver (1) includes: an internal pressure regulating valve (5) provided above a tightly sealed cabinet (2), for allowing ventilation inside and outside the cabinet (2); and moisture adjustors (7), each having a moisture absorbing function, fixed inside the cabinet (2).

Furthermore, the cabinet (2) includes a fore cabinet (10) having an image receiver disposed therein and a rear cabinet (11) for radiating heat from the inside, the rear cabinet (11) including a rear frame (3) having a fin (33) formed therein and exposed outward and a sealing plate (4) for covering an opening (31) formed at the rear frame (3), which is constituted by joining metallic rear frame constituting pieces (30) to one another, the fin (33) being formed integrally with the rear frame constituting piece (30).

With the above-described structure, the present invention has the following effects:
1. Although change in pressure inside the cabinet (2) can be controlled by the internal pressure regulating valve (5), the internal pressure regulating valve (5) may cause entering of water vapor outside the cabinet (2). When the temperature outside the cabinet (2) is decreased, relative humidity is increased, and therefore, condensation is likely to occur.
   In view of this, the moisture adjustor (7) absorbs the water vapor so as to decrease the relative humidity, thus preventing occurrence of the condensation. In the case of increase in temperature inside the cabinet (2), the relative humidity is decreased. At this time, the moisture adjustor (7) discharges the moisture absorbed in itself.
   In this manner, the combination of the moisture adjustor (7) and the internal pressure regulating valve (5) can keep air tightness outdoors for a long period of time, and further, can suppress occurrence of the condensation inside the cabinet (2) for a long period of time.
2. Since the metallic rear frame (3) having the fin (33) disposed therein is exposed outward, heat radiated from the inside of the rear cabinet (11) can be radiated outward even if the rear cabinet (11) is tightly sealed with the rear frame (3) and the sealing plate (4). Moreover, since the rear cabinet (11) is tightly sealed, water or the like also can be prevented from entering the rear cabinet (11).

### BRIEF DESCRIPTION OF THE DRAWINGS

Fig. 1 is a perspective view showing a television image receiver according to a preferred embodiment, as viewed from the front;
Fig. 2 is a perspective view showing the television image receiver according to the preferred embodiment, as viewed from the back;
Fig. 3 is a back view showing the television image receiver according to the preferred embodiment;
Fig. 4 is a cross-sectional view cut away on a plane including a line B-B of Fig. 1;
Fig. 5 is an enlarged cross-sectional view showing an internal pressure regulating valve;
Fig. 6 is a front view showing a sealing plate;
Fig. 7 is a perspective view showing an eyebolt;
Fig. 8 is a perspective view showing another eyebolt;
Fig. 9 is a diagram illustrating numerous television image receivers connected to a single controller via a device;
Fig. 10 is an enlarged view showing a fore frame constituting piece and a rear frame constituting piece shown in Fig. 4, as viewed on a left side;
Fig. 11 is an exploded perspective view showing a fore frame constituting piece on the left of a fore cabinet joined to a fore frame constituting piece at an upper end shown in Fig. 1;
Fig. 12 is a cross-sectional view cut away on a plane including a line C-C of Fig. 11;
Fig. 13 is a cross-sectional view cut away on a plane including a line A-A of Fig. 3;
Fig. 14 is a perspective view showing the assemblage of the adjacent rear frame constituting pieces;
Figs. 15A and 15B are front views showing the assemblage of the adjacent rear frame constituting pieces; and
Fig. 16 is a cross-sectional view showing another rear frame constituting piece.

### DETAILED DESCRIPTION OF THE PREFERRED EMBODIMENTS

One preferred embodiment according to the present invention will be described in detail below with reference to the attached drawings.

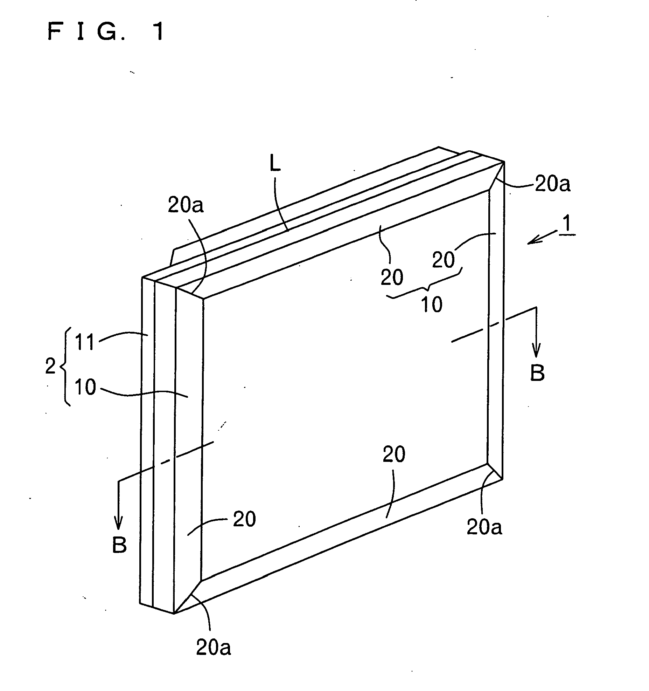

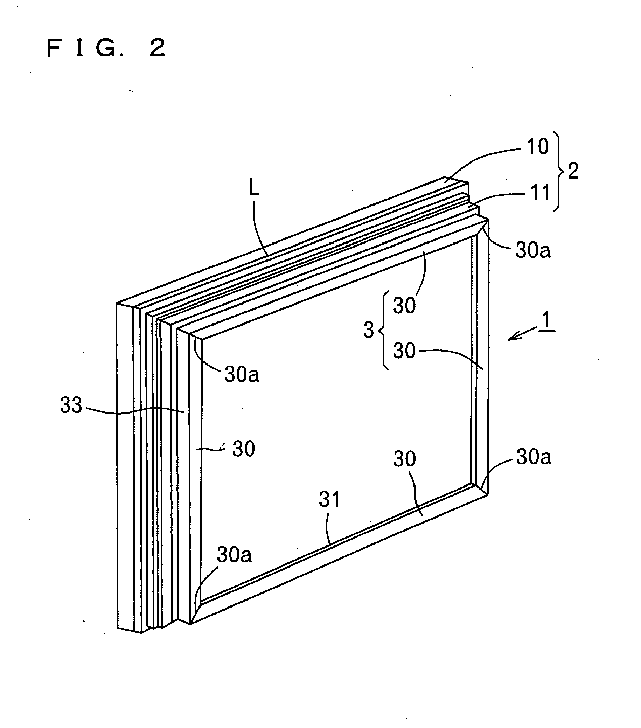

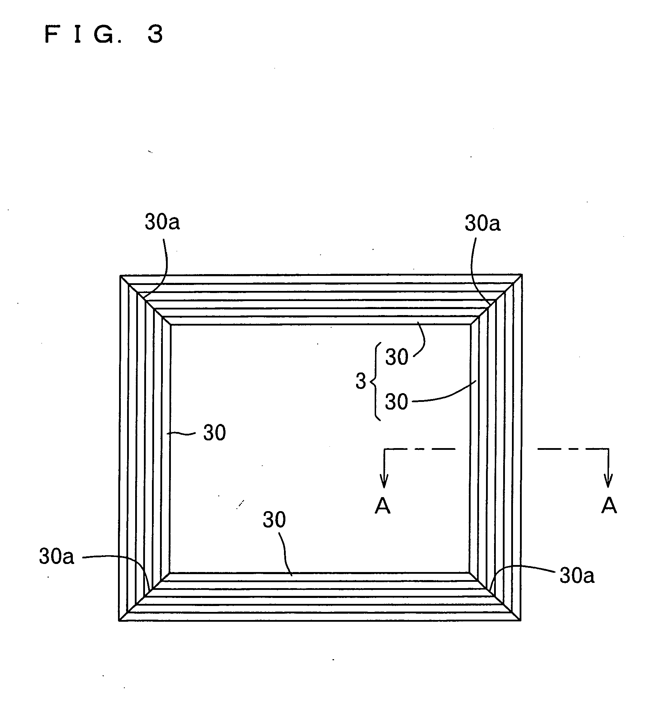

Fig. 1 is a perspective view showing a television image receiver (1) according to the present embodiment, as viewed from the front; Fig. 2 is a perspective view showing the television image receiver according to the present embodiment, as viewed from the back; and Fig. 3 is a back view showing the television image receiver according to the present embodiment. The television image receiver (1) includes a cabinet (2) serving as an outward appearance part, which is constituted of a fore cabinet (10) having an image receiver such as a liquid crystal panel or a plasma display panel disposed therein and a rear cabinet (11) for radiating heat from the inside. A demarcation line defined between both of the cabinets (10) and (11) is designated by reference character L in Figs. 1 and 2.

The rear cabinet (11) includes a metallic rear frame (3) having a fin (33) formed therein, and further, the rear frame (3) is constituted by joining four elongated rear frame constituting pieces (30) to one another in a rectangular shape. The fin (33) extends over the entire length of the rear frame constituting pieces (30).

The fore cabinet (10) is constituted by joining four fore frame constituting pieces (20) to one another in a rectangular shape. A rear opening (31) formed at the rear frame (3) is covered with a sealing plate (4), so that the cabinet (2) is tightly sealed, as described later.

Assuming that the television image receiver (1) in the present embodiment is used outdoors, it is possible to prevent entering of rainwater and the like into the inside of the cabinet (2) since the cabinet (2) is tightly sealed. Internal air of a high temperature due to heat generated in an internal circuit comes into contact with the rear frame (3), and then, the heat can be radiated to the outside.

Each of the fore frame constituting pieces (20) is specifically formed by extruding aluminum. In other words, the fore frame constituting piece (20) is constituted by cutting out an elongated material (not shown), which is obtained by extruding aluminum, into pieces having a desired length. An end surface (20a) of the fore frame constituting piece (20) is inclined at an angle of about 45° in a longitudinal direction of the fore frame constituting piece (20). Consequently, the adjacent fore frame constituting pieces (20) can be joined to each other in a manner substantially perpendicular to each other.

Similarly, as shown in Figs. 2 and 3, each of the rear frame constituting pieces (30) is formed by extruding aluminum. An end surface (30a) of the rear frame constituting piece (30) is inclined at an angle of about 45° in a longitudinal direction of the rear frame constituting piece (30).

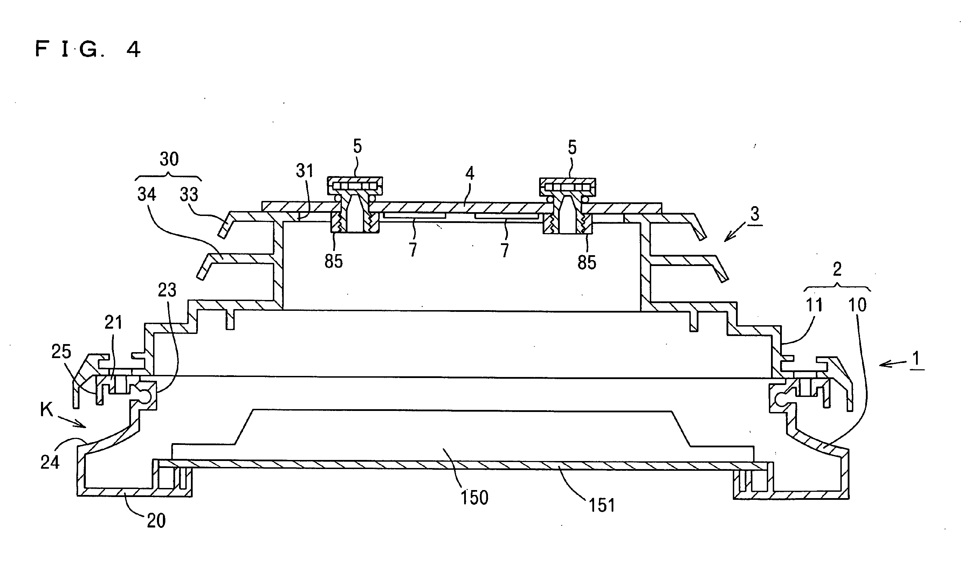

Fig. 4 is a cross-sectional view cut away on a plane including a line B-B of Fig. 1. The rear frame constituting piece (30) includes the plurality of fins (33) in multiple stages. The rear opening (31) formed at the rear frame (3) is covered with the sealing plate (4). In this manner, it is possible to prevent entering of water and the like into the rear cabinet (11) since the rear cabinet (11) is tightly sealed. Moreover, since the metallic rear frame (3) having the fin (33) is exposed outward, the heat generated inside the rear cabinet (11) can be radiated outward even if the rear cabinet (11) is tightly sealed with the rear frame (3) and the sealing plate (4).

As shown in Fig. 4, a transparent cover plate (151) is fixed in front of a panel unit (150) serving as an image receiver inside the fore cabinet (10). The cover plate (151) is made of glass or an acrylic material, thereby protecting the panel unit (150) from scratches or the like and imparting a waterproof effect. In other words, the cover plate (151) can prevent entering of water into the fore cabinet (10) with a high waterproof effect in comparison with a configuration in which a fore surface of the panel unit (150) is exposed to the outside.

### Condensation Preventing Structure

The rear opening (31) formed at the rear frame (3) is covered with the sealing plate (4), so that the rear cabinet (11) is tightly sealed. Internal pressure regulating valves (5) are disposed at two points on the sealing plate (4) in separation from each other. Inside of the sealing plate (4) are secured moisture adjustors (7) having a moisture absorbing function in the vicinity of the internal pressure regulating valves (5), respectively. As described above, the internal pressure regulating valves (5) are provided for alleviating the change in pressure inside the cabinet (2). Although the locations of the moisture adjustors (7) are not limited at the positions shown in Fig. 4, they are preferably disposed in the vicinity of the internal pressure regulating valves (5), through which the water vapor comes and goes.

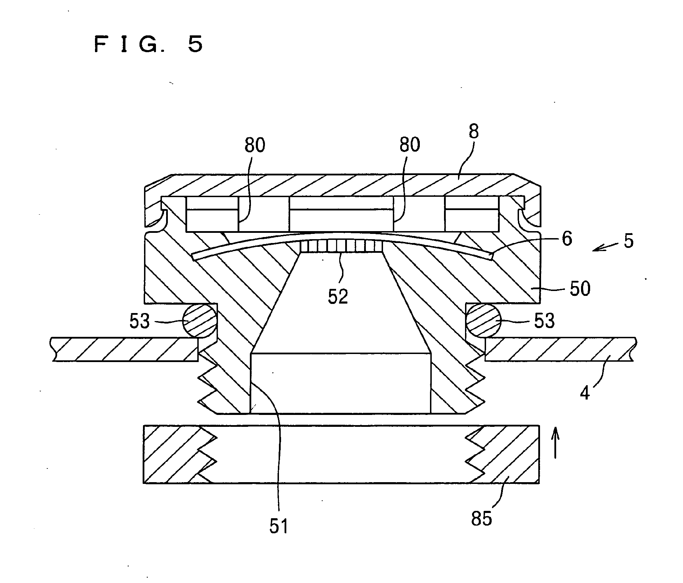

Fig. 5 is an enlarged cross-sectional view showing the internal pressure regulating valve (5). A valve body (50) is covered at the upper surface thereof with a cap (8). Air flowing-in holes (80) are opened at the side surfaces of the cap (8). The lower end of the valve body (50) is screwed with a nut (85) inside the sealing plate (4), and then, is fixed to the sealing plate (4). A ventilation hole (51) having an opened lower surface is formed at a center in a planar direction of the valve body (50), and further, a mesh portion (52) is formed at the upper surface of the ventilation hole (51). A ventilation filter (6) is placed on the mesh portion (52). Air and water vapor permeate the ventilation filter (6), but water cannot permeate the ventilation filter (6). An O-ring (53) is fitted around the valve body (50), thereby enhancing tightness with the sealing plate (4).

Air staying inside the cabinet (2) is discharged to the outside of the cabinet (2) through the ventilation hole (51), the mesh portion (52), the ventilation filter (6) and the holes (80). To the contrary, the air outside the cabinet (2) enters into the cabinet (2) through the holes (80), the ventilation filter (6), the mesh portion (52) and the ventilation hole (51). At this time, the water vapor enters into the cabinet (2) through the ventilation filter (6), although in a very small quantity.

When temperature outside the cabinet (2) is decreased, temperature inside the cabinet (2) is abruptly decreased since the rear frame (3) is made of aluminum having a heat absorbing effect. Naturally, relative humidity is increased. As is well known, the relative humidity is obtained by dividing a quantity of water vapor in the air by a quantity of water vapor which can be contained in the air. Therefore, if the relative humidity exceeds 100%, the water vapor in excess of the saturated water vapor in quantity becomes condensed.

In view of this, the moisture adjustor (7) absorbs the water vapor to decrease the relative humidity, thereby preventing occurrence of condensation. The combination of the moisture adjustor (7) with the internal pressure regulating valve (5) can keep air tightness since change in pressure inside the cabinet (2) is small even if the outside temperature is decreased.

A moisture quantity absorbed by the moisture adjustor (7) is limited. However, the relative humidity is decreased in the case where the temperature inside the cabinet (2) is increased after the energization of the television image receiver. At this time, the moisture adjustor (7) discharges the moisture absorbed in itself. In addition, the moisture adjustor (7) also has the function of discharging the moisture from the inside of the cabinet (2) to the outside of the cabinet (2) by means of the internal pressure regulating valve (5) when the humidity outside the cabinet (2) is low.

In this manner, the combination of the moisture adjustor (7) with the internal pressure regulating valve (5) can keep the air tightness outdoors for a long period of time, and further, can produce the effect of suppressing occurrence of the condensation inside the cabinet (2) for a long period of time.

There are various types of moisture adjustors (7). The present applicant proposes a sheet made of a synthetic rubber including a high water absorbing polymer therein, covered with non-woven fabric as one example. The moisture adjustor (7) absorbs 0.6 g of moisture per gram with a specific gravity of 1.3, but it is not limited to these physical properties.

### Sealing Plate

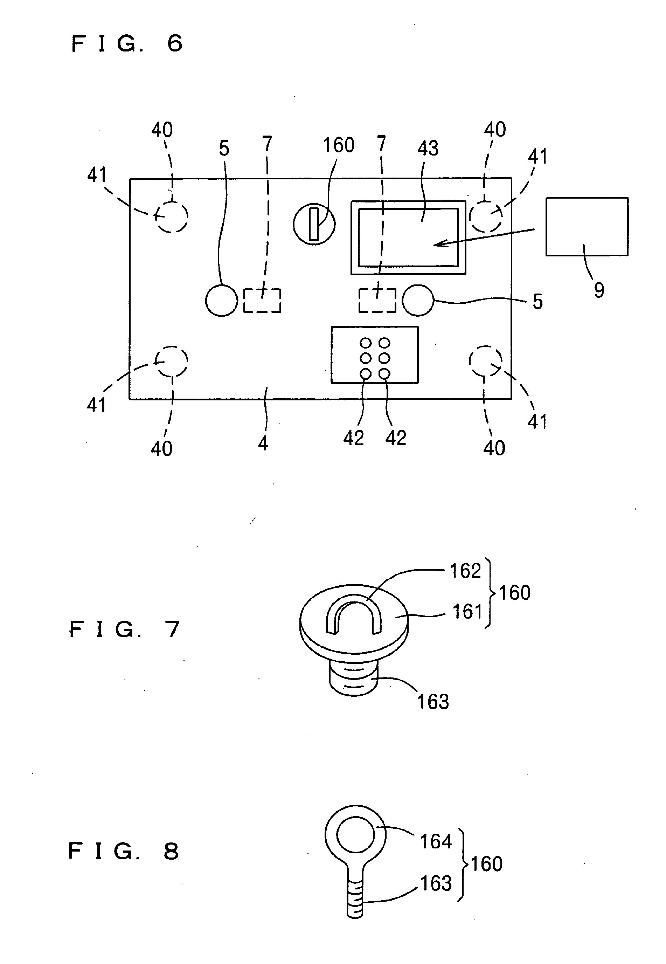

Fig. 6 is a front view showing the sealing plate (4). At four corners of the sealing plate (4) are opened through holes (40), to which air permeable and water repellent sheet members (41) are stuck, respectively. Specifically, GORE-TEX (registered trademark) manufactured by Japan Gore-Tex, Inc. is used. As a result, droplets from the outside can be prevented from entering the rear cabinet (11), while the heated air from the inside can pass through not only the internal pressure regulating valve (5) but also the sheet member (41). Here, the through holes (40) may be formed at the four corners, as shown in Fig. 6; otherwise, they may be formed only at two upper corners.

Furthermore, to the sealing plate (4) is attached a theftproof connecting tool, specifically, an eyebolt (160) shown in Fig. 7. The eyebolt (160) includes a semicircular stopper (162) on a supporting plate (161). A chain is passed through the stopper (162), and then, is secured at one end thereof to a pillar or wall as a theft-prevention measure of the television image receiver (1). Such a theft-prevention measure is necessary on the assumption that the television image receiver (1) is used outdoors, as described above.

The eyebolt (160) is screwed with the sealing plate (4) via a bolt (163) projecting from the supporting plate (161). Here, the eyebolt (160) may be welded or bonded to the sealing plate (4) without any bolt (163). Alternatively, a bolt (163) may be formed at a stopper ring (164), as shown in Fig. 8.

In addition to terminals (42) for video and audio transmission, a recess surface (43) accommodating a remote control device (9) is disposed in the sealing plate (4). The recess surface (43) is covered with a waterproof and dustproof cover member (not shown). The device (9) is housed inside the television image receiver (1), so that it does not become an obstacle in using the television image receiver (1) in a state hanged on the wall.

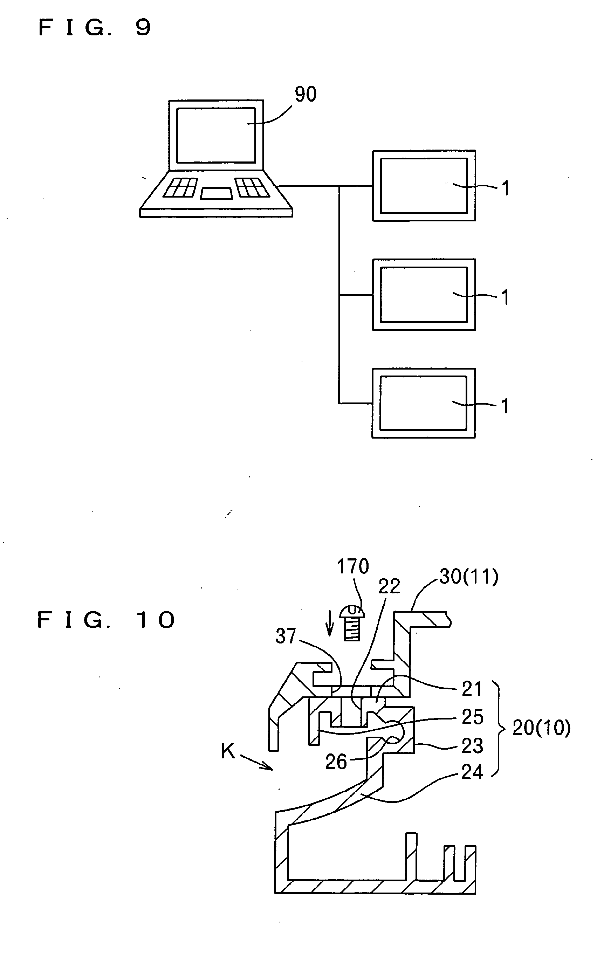

The remote control device (9) is specifically used when the numerous television image receivers (1) are connected to a single controller (90), as shown in Fig. 9. The connection of the controller (90) to each of the television image receivers (1) via the device (9) enables the numerous television image receivers (1) to switchably display images thereon at one time by the single controller (90). Alternatively, the single television image receiver (1) can be controlled via a network by connecting the device (9) to the network.

### Cabinet Assembling Structure

Fig. 10 is an enlarged view showing the fore frame constituting piece (20) and the rear frame constituting piece (30) shown in Fig. 4, as viewed on a left side. From the fore frame constituting piece (20), a receiving plate (21) that faces the rear cabinet (11) projects outward to the side. A hole (22) for a first self tapping screw (170), which screws the fore frame constituting piece (20) and the rear cabinet (11) with each other, is formed at the receiving plate (21). The first self tapping screw (170) is screwed to the fore frame constituting piece (20) from the side of the rear frame constituting piece (30).

The fore frame constituting piece (20) integrally includes a first strip member (23) located inward of the receiving plate (21), a second strip member (24) facing the front of the receiving plate (21) and a third strip member (25) located outward of the receiving plate (21). The receiving plate (21), the first strip member (23) and the second strip member (24) define a space K inside thereof. The space K is opened at the lateral side and lower side. At the first strip member (23) is formed a recessed screw hole (26) for the self tapping screw to be screwed with the adjacent fore frame constituting piece (20). The screw hole (26) is formed into a substantially circular shape in cross section, and extends over the entire length of the fore frame constituting piece (20), as described later.

In joining the fore cabinet (10) and the rear cabinet (11) to each other, the first self tapping screw (170) is screwed into the hole (22) through a through hole (37) opened at the rear frame constituting piece (30). Since the first self tapping screw (170) is screwed while forming taps at a circumferential surface of the hole (22), machining dust is produced on the circumferential surface of the hole (22). The machining dust is discharged sideways or downward from the space K.

As described above, the hole (22) for the first self tapping screw (170) is formed at the receiving plate (21) projecting outward to the side from the fore frame constituting piece (20), so that the machining dust produced during the screwing of the first self tapping screw (170) do not enter the fore cabinet (10) or the rear cabinet (11) but can be discharged sideways or downward from the space K. As a consequence, no disturbance is produced by the machining dust formed during the self tapping, on the operation of the internal circuit disposed inside the fore cabinet (10) or the rear cabinet (11). Water and the like can be prevented from entering the fore cabinet (10) or the rear cabinet (11) from the hole (22) for the first self tapping screw (170).

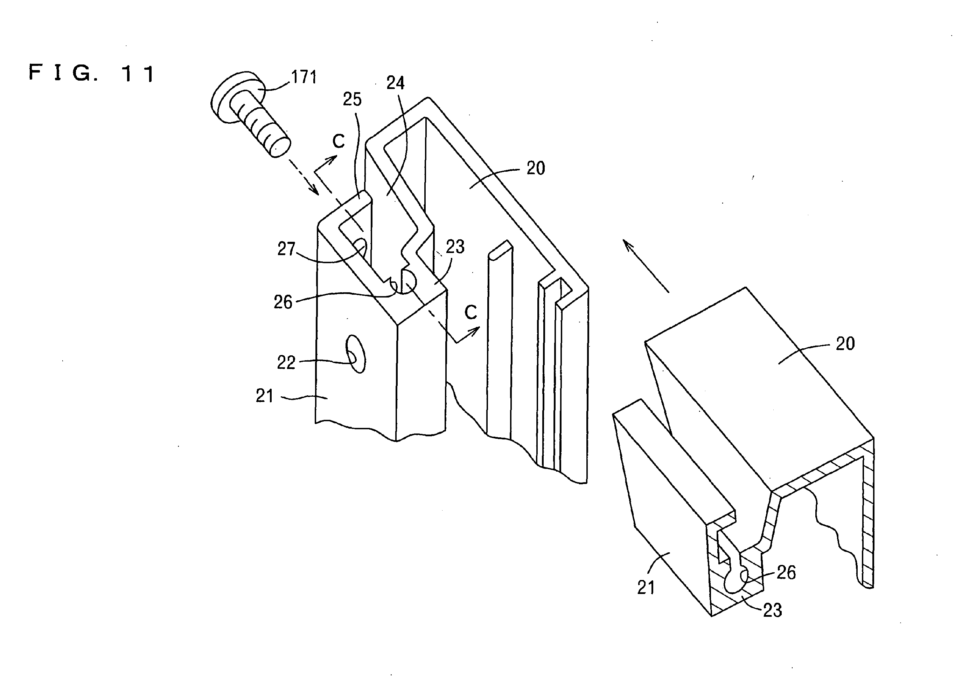

Fig. 11 is an exploded perspective view showing the fore frame constituting piece (20) on the left of the fore cabinet (10) shown in Fig. 1 joined to the fore frame constituting piece (20) at an upper end. As described above, both of the fore frame constituting pieces (20) are adjacent to each other, to be joined to each other via a second self tapping screw (171) from the outside of the fore frame constituting piece (20) on the left. Here, both of the fore frame constituting pieces (20) are constituted by cutting out an elongated material molded by extruding aluminum, and therefore, they are identical in cross-sectional shape to each other.

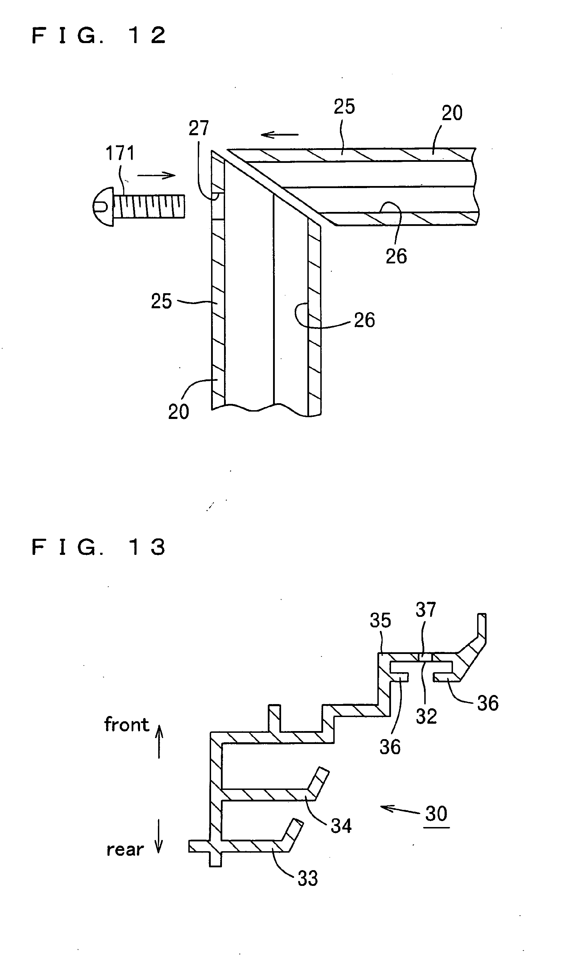

Fig. 12 is a cross-sectional view cut away on a plane including a line C-C of Fig. 11. At the third strip member (25) in the fore frame constituting piece (20) on the left is opened a through hole (27), into which the second self tapping screw (171) is inserted. The second self tapping screw (171) is screwed with the screw hole (26) formed at the fore frame constituting piece (20) at the upper end through the through hole (27). In this manner, the adjacent fore frame constituting pieces (20) perpendicular to each other are joined to each other.

In the present embodiment, the screw hole (26) penetrates over the entire length of the fore frame constituting piece (20). This is because the fore frame constituting piece (20) is formed by extruding, and therefore, the screw hole (26) need not always penetrate over the entire length.

Moreover, the joint state of the fore frame constituting piece (20) on the left and the fore frame constituting piece (20) at the upper end is merely shown by way of example, and therefore, the other adjacent fore frame constituting pieces (20) are also joined to each other in the same manner.

Fig. 13 is a cross-sectional view cut away on a plane including a line A-A of Fig. 3. As shown in Fig. 13, the rear frame constituting piece (30) includes a plurality of fins (33), (34) and (35) in multiple stages. The tips of the first and second fins (33) and (34) located outside, that is, on a back side are bent forward. Stopper pieces (36) projects inward from the third fin (35) located at the front. A recessed groove (32) extending over the entire length of the rear frame constituting piece (30) is defined between the stopper pieces (36) and the third fin (35). The through hole (37) is opened at the third fin (35). In order to join the adjacent rear frame constituting pieces (30) to each other in a manner substantially perpendicular to each other, respective end surfaces of the recessed grooves (32) face each other.

### Guide Member

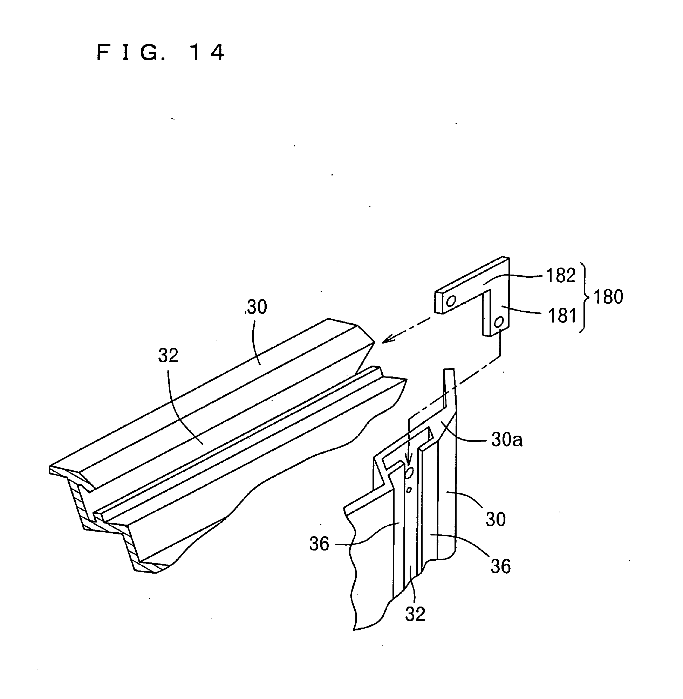

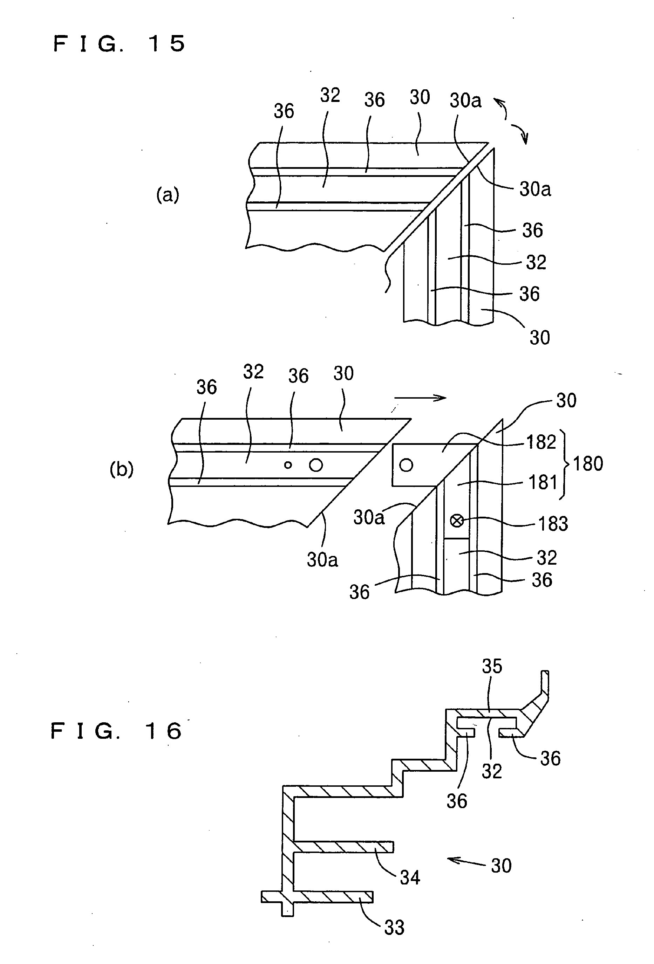

Fig. 14 is a perspective view showing the assemblage of the adjacent rear frame constituting pieces (30) so as to configure the rectangular rear frame (3); and Figs. 15A and 15B are front views in the assemblage. As described above, in order to join the adjacent rear frame constituting pieces (30) to each other in a manner substantially perpendicular to each other, the respective end surfaces (30a) of the rear frame constituting pieces (30) are made to face each other.

However, the rear frame constituting piece (30) is long and heavy in the television image receiver (1) having a large image receiver, and therefore, a wobble occurs in joining both of the rear frame constituting pieces (30) to each other, as shown in Fig. 15A, so that the respective end surfaces (30a) of the rear frame constituting pieces (30) sometimes cannot be faced with each other accurately.

In view of this, as shown in Figs. 14 and 15B, it is devised that the end surfaces (30a) are positioned by fitting a substantially L-shaped guide member (180) into each of the recessed grooves (32).

The guide member (180) is made of a metallic plate material including a vertical first piece (181) and a horizontal second piece (182) which are perpendicular to each other. In joining the rear frame constituting pieces (30) to each other, the first piece (181) of the guide member (180) is fitted into the recessed groove (32) formed at one of the rear frame constituting pieces (30), to be fixed via a screw (183), as shown in Fig. 15B. Subsequently, the other rear frame constituting piece (30) is moved toward the above-described rear frame constituting piece (30), and then, the second piece (182) is fitted into the recessed groove (32) formed at the other rear frame constituting piece (30). That is to say, the guide member (180) guides the fixture of the other rear frame constituting piece (30), thus accurately fixing both of the rear frame constituting pieces (30) in a manner perpendicular to each other. Here, the second piece (182) may be first fitted into the recessed groove (32) formed at one of the rear frame constituting pieces (30), and then, the first piece (181) may be fitted into the recessed groove (32) formed at the other rear frame constituting piece (30).

Although in the above-described embodiment, the tips of the first and second fins (33) and (34) in the rear frame constituting piece (30) are bent forward, they may extend straight, as shown in Fig. 16.

Alternatively, although it is assumed that the television image receiver (1) is used outdoors in the above-described embodiment, it may be used not only outdoors but also indoors.

## Claims

1. A television image receiver comprising a cabinet (2), the television image receiver being **characterized in that**:
an internal pressure regulating valve (5) provided above the tightly sealed cabinet (2), for allowing ventilation inside and outside the cabinet (2); and
moisture adjustors (7), each having a moisture absorbing function, fixed inside the cabinet (2).

2. The television image receiver according to claim 1, wherein the internal pressure regulating valve (5) includes a ventilation filter (6), the ventilation filter (6) allowing air and water vapor to pass therethrough but preventing water from passing therethrough.

3. The television image receiver according to claim 1 or 2, wherein
the cabinet (2) includes a fore cabinet (10) having an image receiver disposed therein and a rear cabinet (11) for radiating heat from the inside,
the rear cabinet (11) includes a rear frame (3) having a fin (33) exposed outward and a sealing plate (4) for covering an opening (31) at the rear frame (3), and
the rear frame (3) is constituted by joining metallic rear frame constituting pieces (30) to one another, and the fin (33) is formed integrally with the rear frame constituting piece (30).

4. The television image receiver according to claim 1 or 2, wherein
the cabinet (2) includes a fore cabinet (10) having an image receiver disposed therein and a rear cabinet (11) for radiating heat from the inside,
the fore cabinet (10) is constituted by joining metallic fore frame constituting pieces (20) to one another,
a receiving plate (21) facing the rear cabinet (11) projects from the fore frame constituting piece (20) outward to the side, and
a hole (22) for a self tapping screw (170) for screwing the fore frame constituting piece (20) and the rear cabinet (11) to each other is formed at the receiving plate (21).

5. The television image receiver according to claim 1 or 2, wherein
the cabinet (2) includes a fore cabinet (10) having an image receiver disposed therein and a rear cabinet (11) for radiating heat from the inside,
the rear cabinet (11) includes a rear frame (3) having a fin (33) exposed outward,
the rear frame (3) is formed by joining four metallic rear frame constituting pieces (30) to one another in a rectangular shape with the adjacent rear frame constituting pieces (30) substantially perpendicular to each other,
the rear frame constituting piece (30) has a recessed groove (32) extending along a longitudinal direction of the rear frame constituting piece (30) and having an end surface in conformity with an end surface of the rear frame constituting piece (30), and
a guide member (180) for guiding the perpendicular fixture of the adjacent rear frame constituting pieces (30) is fitted into the recessed grooves (32) formed at both of the adjacent rear frame constituting pieces (30).

6. A television image receiver comprising a cabinet (2), the television image receiver being **characterized in that**:
the cabinet (2) includes a fore cabinet (10) having an image receiver disposed therein; and a rear cabinet (11) for radiating heat from the inside,
the rear cabinet (11) includes a rear frame (3) having a fin (33) exposed outward and a sealing plate (4) for covering an opening (31) formed at the rear frame (3), and
the rear frame (3) is constituted by joining metallic rear frame constituting pieces (30) to one another, and the fin (33) is formed integrally with the rear frame constituting piece (30).

7. The television image receiver according to claim 6, wherein the fin (33) is formed integrally with the rear frame constituting piece (30) by metal extruding.

8. The television image receiver according to claim 6 or 7, wherein a transparent cover plate (151) is fixed inside the fore cabinet (10) in front of a panel unit (150) serving as an image receiver, to prevent water from coming in.

9. A television image receiver comprising a cabinet (2), the television image receiver being **characterized in that**:
the cabinet (2) includes a fore cabinet (10) having an image receiver disposed therein; and a rear cabinet (11) for radiating heat from the inside,
the fore cabinet (10) is constituted by joining metallic fore frame constituting pieces (20) to one another,
a receiving plate (21) facing the rear cabinet (11) projects from the fore frame constituting piece (20) outward to the side, and
a hole (22) for a self tapping screw (170) for screwing the fore frame constituting piece (20) and the rear cabinet (11) to each other is formed at the receiving plate (21).

10. The television image receiver according to claim 9, wherein
the fore frame constituting piece (20) includes, at its lateral side, a first strip member (23) located inward of the receiving plate (21), and a second strip member (24) facing the receiving plate (21) before the receiving plate (21), and
a space K defined by the receiving plate (21), the first strip member (23) and the second strip member (24) has its lateral side and lower side opened to discharge machining dust produced during self tapping.

11. The television image receiver according to claim 10, wherein the adjacent fore frame constituting pieces (20) are joined in a manner substantially perpendicular to each other, and a screw hole (26) for a self tapping screw to be screwed with the adjacent fore frame constituting piece (20) is formed at the first strip member (23).

12. A television image receiver comprising a cabinet (2), the television image receiver being **characterized in that**:
the cabinet (2) includes a fore cabinet (10) having an image receiver disposed therein; and a rear cabinet (11) for radiating heat from the inside,
the rear cabinet (11) includes a rear frame (3) having a fin (33) exposed outward,
the rear frame (3) is formed by joining four metallic rear frame constituting pieces (30) to one another in a rectangular shape with the adjacent rear frame constituting pieces (30) substantially perpendicular to each other,
the rear frame constituting piece (30) has a recessed groove (32) extending along a longitudinal direction of the rear frame constituting piece (30) and having an end surface in conformity with an end surface of the rear frame constituting piece (30), and
a guide member (180) for guiding the perpendicular fixture of the adjacent rear frame constituting pieces (30) is fitted into the recessed grooves (32) formed at both of the adjacent rear frame constituting pieces (30).

13. The television image receiver according to claim 12, wherein the rear cabinet (11) is tightly sealed by covering the rear frame (3) with a sealing plate (4), an antitheft connecting tool being fixed to the sealing plate (4).

14. The television image receiver according to claim 12, wherein the rear cabinet (11) is tightly sealed by covering the rear frame (3) with a sealing plate (4), and a water repellent sheet member (41) having air permeability is stuck to a through hole (40) bored at the sealing plate (4).

15. The television image receiver according to claim 12, wherein the rear cabinet (11) is tightly sealed by covering the rear frame (3) with a sealing plate (4), and a recess surface (43) for accommodating a remote control device (9) is formed at the sealing plate (4).
